# EUROPEAN PATENT SPECIFICATION

(11) **EP 1 790 022 B1**
(45) Date of publication and mention of the grant of the patent: **07.09.2011**
(21) Application number: 05776304.7
(22) Date of filing: 22.07.2005
(51) Int. Cl.: H01L 51/00, H05K 3/18

(54) **DEPOSITING MATERIAL ON PHOTOSENSITIVE MATERIAL**
ABLAGERUNG VON MATERIAL AUF LICHTEMPFINDLICHEM MATERIAL
DEPOT DE MATERIAU SUR UN MATERIAU PHOTOSENSIBLE

(30) Priority: 06.08.2004 US 912888
(43) Date of publication of application: 30.05.2007
(73) Proprietor: HEWLETT-PACKARD DEVELOPMENT COMPANY, L.P., Houston TX 77070 (US)
(72) Inventor: LEITH, Steven D, Corvallis, Oregon 97330-4239 (US); HERMAN, Gregory S., Corvallis, Oregon 97330-4239 (US)
(74) Representative: Samson & Partner
(86) International application number: PCT/US2005/026033
(87) International publication number: WO 2006/020349

(56) References cited:
- EP-A- 0 397 988
- EP-A- 0 428 870
- WO-A-02/095805
- WO-A-03/086024
- US-A- 4 643 798

## Description

### DEPOSITING MATERIAL ON PHOTOSENSTIVE MATERIAL

### BACKGROUND

Electronic devices, such as integrated circuits, solar cells, and/or electronic displays, for example, may be comprised of one or more substrates, in which the one or more substrates may have one or more structures that are conductive formed thereon. Methods of forming substrates, such as these, may vary, but typically, employ approaches that may be time consuming, expensive, and/or produce results that are less than desired.

WO 02/095805 describes a method in which layers of conducting, semiconducting, insulating or surface modifying layers are deposited on a substrate and high resolution patterns are defined in these layers by exposure to a focussed laser beam. The device may include a light absorbing layer to increase the efficiency of the laser.

### BRIEF DESCRIPTION OF THE DRAWINGS

Subject matter is particularly pointed out and distinctly claimed in the concluding portion of the specification. Claimed subject matter, however, both as to organization and method of operation, together with objects, features, and advantages thereof, may best be understood by reference of the following detailed description when read with the accompanying drawings in which:
FIG. 1 a is a side view of one embodiment of a substrate with one or more conductive features formed thereon;
FIG. 1b is a diagram illustrating an embodiment of a system that may be employed to form conductive features on a substrate;
FIG. 2 is a diagram illustrating another embodiment of a system that may be employed to form one or more conductive features on a substrate;
FIG. 3 is a diagram illustrating yet another embodiment of a system that may be employed to form one or more conductive features on a substrate; and
FIG. 4 is flowchart illustrating one embodiment of a method of forming one or more conductive features on a substrate.

### DETAILED DESCRIPTION

In the following detailed description, numerous specific details are set forth to provide a thorough understanding of claimed subject matter. However, it will be understood by those skilled in the art that claimed subject matter may be practiced without these specific details. In other instances, well-known methods, procedures, components and/or circuits have not been described in detail so as not to obscure claimed subject matter.

Electronic devices, such as semiconductor devices and/or display devices, for example, may be comprised of at least one substrate. The at least one substrate may have one or more conductive features formed thereon. These conductive features may comprise patterned conductive lines, referred to generally as traces, and may additionally comprise other conductive features, such as, for example, pads, gates and/or bus bars, and may be comprised of organic and/or inorganic materials, for example. As used herein, conductive, when used, such as with reference to conductive features, for example, generally refers to the capability to at least partially conduct electricity, and may comprise a feature that is conductive, semi-conductive, or at least partially conductive, for example. The at least one substrate and/or the one or more conductive features formed thereon may, in at least one embodiment, comprise one or more electronic devices, such as thin films transistors (TFT), field effect transistors (FET), organic light emitting diodes (OLED), RF-ID tags, smart labels, sensors, digital memory, capacitors, diodes, resistors, photovoltaic cells, insulators, conductors, optically active devices, and/or the like. Thin film devices, such as TFTs, may, for example, be utilized in display devices, including, for example, electroluminescent and/or liquid crystal displays (LCD). Thus, a substrate with one or more conductive features formed thereon may form a portion of an electronic device, such as a display device, for example.

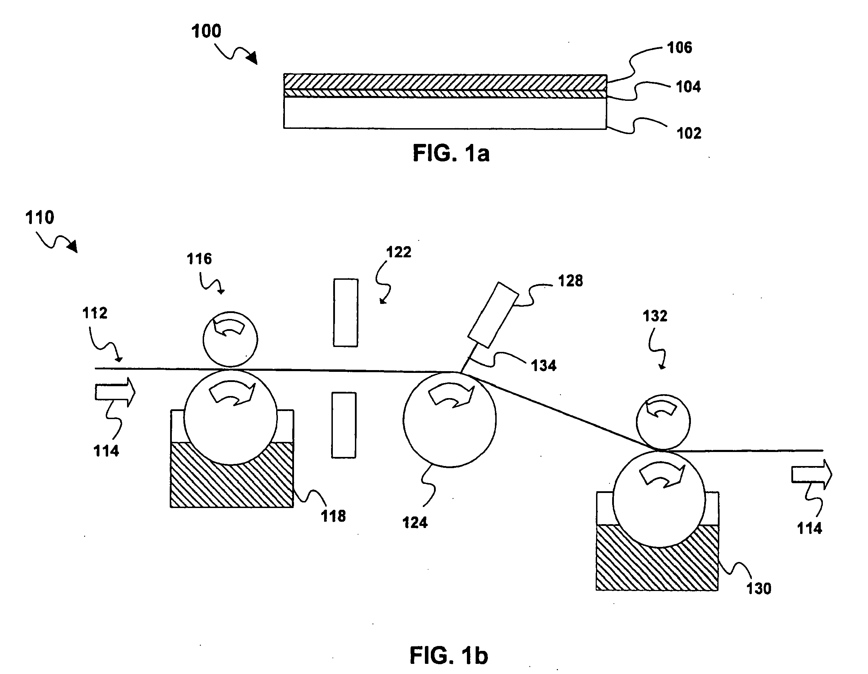

Although claimed subject matter is not so limited, in one particular embodiment, a substrate with one or more conductive features formed above or thereon may be formed by depositing at least one material on or above at least a portion of at least one surface of a substrate and processing at least a portion of the at least one material, which may comprise patterning at least a portion of the deposited material and/or selectively removing at least a portion of the deposited material. Additionally, one or more subsequent deposition, patterning, and/or removal processes may be used to form conductive features, in at least one embodiment. Referring now to FIG. 1a, there is illustrated an embodiment 100 of a substrate with one or more conductive features. Such features may be formed substantially by the process described above, in one embodiment, for example. Embodiment 100 comprises a side view of at least a portion of a substrate, comprising a substrate material 102, with a secondary material layer 104 and a conductive feature layer 106 formed thereon. Of course, in alternative embodiments, one or more other layers may separate and/or replace the aforementioned layers, such as one or more intervening layers, for example. Substrate material 102 may comprise a flexible substrate material, such as a substrate comprising primarily polyester, polyethylene terephthalate (PET), polyethylene naphthalate (PEN), Mylar® material and/or polyimide (e.g. Kapton® material), for example, but claimed subject matter is not so limited. Substrate material 102 may have a secondary material layer 104 formed thereon, which may comprise a coating or a covering of material formed on or above at least a portion of at least one surface of substrate 102, such as a coating or covering formed on a substantial portion of one surface of substrate 102, for example. In one embodiment, secondary material layer 104 may comprise a material or combination of materials that may be at least partially light activated, which may also be referred to as photosensitive materials. In this context, the term photosensitive, when used, for example, with reference to photosensitive materials, refers generally to materials wherein photon bombardment, such as photons from an electromagnetic source, may result in one or more electrons and/or holes being created in conduction and/or valence bands in at least a portion of the material. For example, photosensitive materials capable of being utilized in at least one embodiment may comprise one or a combination of materials, and may comprise organic materials, inorganic materials, and/or a combination thereof, such as one or more types of semiconducting solid oxides, such as oxides of titanium, tantalum, tungsten, vanadium, niobium, zinc, tin, and/or indium, such as TiO₂ and/or any combination thereof, and/or one or more sulfides of tin, iron, cadmium, molybdenum, and/or copper, such as CdS, as just a few examples; although, again, claimed subject matter is not so limited. Additionally, as stated previously, the substrate material 102 may comprise any combination of materials, such as polyester, PET, PEN, Mylar material and/or Kapton material, but it is desirable to note that claimed subject matter is not limited in this respect, and may comprise any material suitable for use as a substrate, such as any material exhibiting properties suitable for application as a substrate in an electronic device, for example.

At least a portion of at least one surface of substrate material 102 have conductive features formed thereon, illustrated as conductive feature layer 106. Although not limited in this respect, one or more conductive features of conductive feature layer 106 may comprise patterned conductive features including, for example, traces, pads, gates and/or bus bars, or any combination thereof, for example. Additionally, a substrate, such as substrate material 102, may be used as part of an electronic device, such as an LCD device, as explained previously. Although claimed subject matter is not limited in this respect, one or more conductive features of conductive feature layer 106 may comprise one or more layers of conductive and/or semiconductive materials. Particular material(s) and/or material combinations may depend at least in part on processes used to form a device, such as device 100, and/or the type of device formed, explained in more detail later.

Conductive feature layer 106 of FIG. 1a may be formed by use of a conductive feature formation system, such as the embodiment at least partially illustrated in FIG. 1b. Illustrated in FIG. 1b is an embodiment of a conductive feature formation system 110; however, this is merely one example of a system illustrating an embodiment of claimed subject matter, and numerous other methods and/or systems may be utilized to form a substrate with one or more conductive features, such as substrate 102 of FIG. 1a. For example, one or more electroless and/or electrolytic plating processes may be utilized to at least partially form one or more conductive features, explained in more detail later. Additionally, many other system embodiments are possible and included within the scope of claimed subject matter. For this particular embodiment, however, 110, performs operations that may be implemented by use of software executing on, for example, a processor, hardware circuits, firmware, any combination thereof, and/or the like. Such software may, for example, be configured to perform processing by interacting with and/or directing the actions of one or more components of formation system 110, to perform various operations, as described in more detail below.

System 110 may be referred to generally as a reel-to-reel (RtR) processing system, although, it is desirable to note that this is merely one particular method of forming a device, such as device 100, and claimed subject matter is not so limited. In this particular context, a RtR processing system refers to a system for processing that employs transferring material from at least one reel to at least another reel as at least a part of the processing. In an alternative embodiment, however, a substrate with one or more conductive features may not be formed using a RtR system. Nonetheless, continuing with this example, system 110 may include a deposition mechanism 116, which may comprise one or more reels and a material reservoir 118, in at least one embodiment. System 110 may additionally include a drying device 122, and an electromagnetic radiation source 128. Additionally, system 110 may include reel 124, and deposition mechanism 132, which may additionally comprise one or more reels in at least one embodiment, and material reservoir 130, for example.

In operation, for this embodiment, system 110 may at least partially form a substrate with one or more conductive features in the following manner: a substrate material 112, which may comprise a roll of material, in one embodiment, for example, may be provided to system 110. In one embodiment, substrate material 112 may be moved with respect to mechanism 116, such as mechanically, and in a direction such as direction 114, for example, and, in at least one embodiment, may be rolled, pulled and/or conveyed through mechanism 116, for example. Substrate material 112 may comprise one or a combination of materials. In one particular embodiment, for example, substrate material 112 may comprise a flexible substrate of a particular material or combination of materials, with at least one secondary material layer, such as a photosensitive material layer, at least partially coating, covering or residing above one or more surfaces of the substrate, such as illustrated in FIG. 1a, although, as explained previously, claimed subject matter is not so limited. For example, in one embodiment, substrate material 112 may comprise a Mylar substrate with a coating or covering of TiO₂ formed on or above at least a portion of at least one surface of the Mylar substrate, for example, although, again, claimed subject matter is not so limited. Substrate 112 may be moved with respect to mechanism 116, such as mechanically by one or more reels of mechanism 116, for example. Mechanism 116 may be capable of depositing material, such as material from reservoir 118, on to or above at least a portion of at least one surface of substrate 112, for example, such as on or above at least a portion of the aforementioned secondary material layer, and this may be referred to here as roll deposition. However, it is desirable to note that claimed subject matter is not so limited, and any method of depositing a material or combination of materials on to or above at least a portion of one or more surfaces of a substrate is included within claimed subject matter. For example, one or more spraying, spin coating, drip coating, immersion and/or spreading processes may be used in at least one embodiment, and, in one or more of these embodiments. Thus, although not illustrated, one or more other mechanisms other than mechanism 116 may be utilized to perform one or more deposition operations, for example.

Continuing with this example, substrate material 112 with material from reservoir 118 deposited thereon may pass proximate to drying device 122. Drying device 122 may, in one embodiment, comprise a radiative heater, for example, and may be capable of providing thermal energy to substrate material 112, such as to at least partially dry the material deposited by mechanism 116, for example. However, in alternative embodiments, no drying device may be utilized, and/or one or more other types of drying devices may be utilized, such as a blower device capable of blowing air and/or gas to at least partially dry the substrate material 112, and the use and/or type of drying device may depend at least in part on the material(s) deposited on substrate material 112, and/or the composition of substrate material 112, for example. After passing proximate to drying device 122, in this embodiment, substrate material 112 may be moved with respect to roller 124, such as by being rolled at least partially over roller 124. Roller 124 may result in substrate 112 being moved with respect to electromagnetic radiation device 128, and electromagnetic radiation device 128 may provide electromagnetic radiation to at least a portion of substrate material 112, for example. In one embodiment, electromagnetic radiation device 128 may comprise one or more laser devices, but, may, alternatively, comprise a device that produces electromagnetic radiation of a wavelength covering either a limited portion or a substantial portion of the spectrum, such as a device utilizing one or more incandescent lamps, for example. Again, selection of an electromagnetic radiation device 128 may depend at least in part on the composition of substrate material 112, and/or the material(s) deposited on substrate material 112, for example. In one embodiment, electromagnetic radiation device 128 may comprise a laser device, capable of producing a laser beam 134, for example. In this particular embodiment, for example, the laser device may be capable of producing electromagnetic radiation with a power greater than approximately 1 µW/cm², and having a wavelength substantially within the range of approximately 10-800 nanometers (nm). In alternative embodiments, a laser device may comprise a laser having a wavelength substantially within the range of approximately 200 to 400 nm, and having a power of approximately 20,000 µW/cm ², as just an example. In either embodiment, the laser device may be capable of selectively providing laser radiation to one or more portions of substrate 112, such as to one or more portions of a photosensitive material formed on or above substrate 112, for example. Likewise, device 128 may be capable of producing a laser beam 134 at approximately a particular wavelength in the electromagnetic spectrum and having suitable energy to provide localized or "spot" radiation, for example. Additionally, as used herein, selectively, when used, such as with providing laser radiation, for example, generally refers to providing electromagnetic radiation to one or more portions of a material, such as a layer of material, wherein the portions are selected based at least in part on the particular location of the one or more portions, such as with localized or spot radiation, for example.

In at least one embodiment, although claimed subject matter is not so limited, at least a portion of the secondary material layer of substrate 112 may comprise photosensitive material, and at least a portion of the material deposited on or above substrate material 112 may be deposited on or above at least a portion of the photosensitive material, for example. In this embodiment, device 128 may be capable of providing electromagnetic radiation to at least a portion of the photosensitive material, resulting in at least a portion of the photosensitive material being exposed to electromagnetic radiation, for example, which results in chemical changes in at least a portion of the photosensitive material, as explained previously. The selective providing of electromagnetic radiation to portions of photosensitive material may be referred to here as patterning, for example.

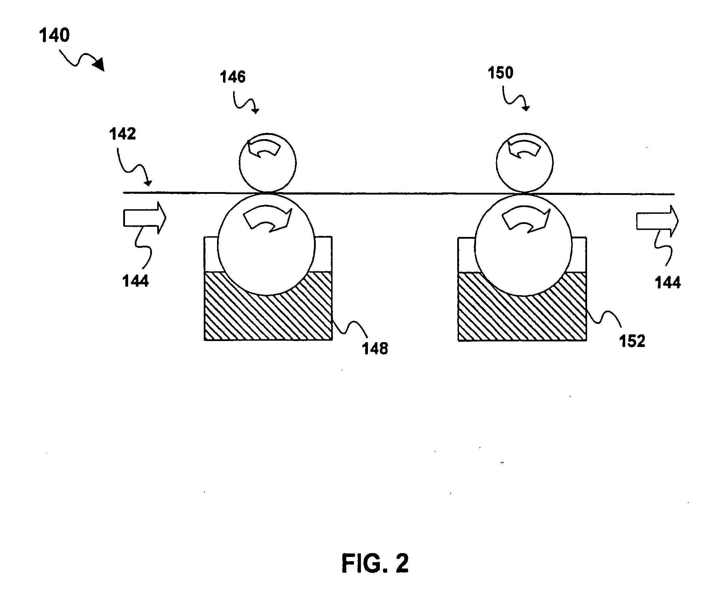

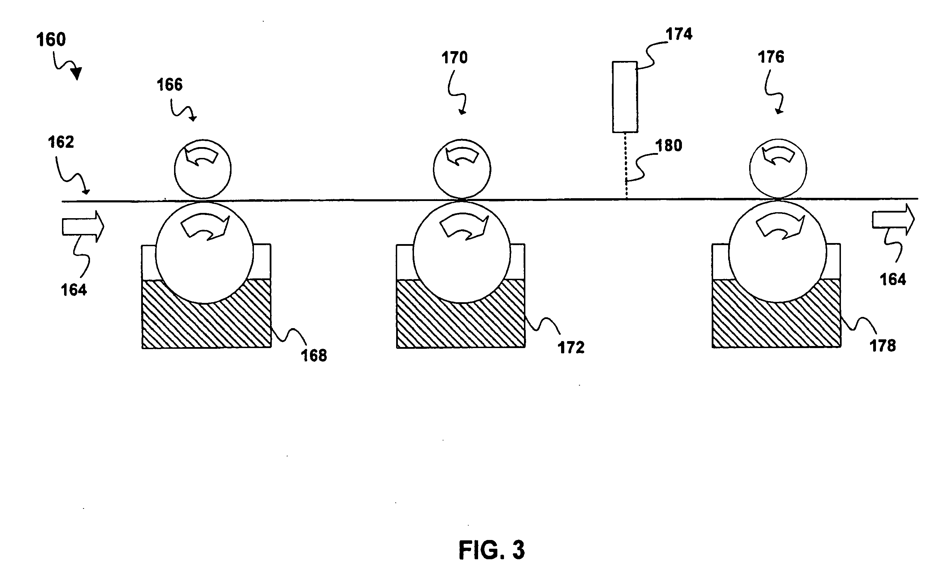

After being provided with electromagnetic radiation, in this embodiment, substrate material 112 may be moved with respect to mechanism 132, for example, and mechanism 132 may deposit a material, such as a material from reservoir 130, for example, and may deposit the material on or above at least a portion of the one or more materials deposited by mechanism 116, for example. In one embodiment, the material may be deposited on or above one or more material deposited by mechanism 116, and/or the portions of the substrate material 112 that were provided with electromagnetic radiation by device 128, for example. This may result in a physical and/or chemical change in at least a portion of the material deposited by mechanism 116, such as a dissolving and/or removing of at least a portion of the material, but, of course, claimed subject matter is not so limited. In one embodiment, portions of a material deposited by mechanism 116, and at least partially provided with electromagnetic radiation by device 128 may react physically and/or chemically with one or more materials deposited by mechanism 132, and at least a portion of the materials may be dissolved and/or removed from substrate 112, for example. Substrate material 112 may have one or more additional processes performed thereon, such as in one or more other embodiments, and/or illustrated by FIGs. 2 and/or 3, and explained in more detail hereinafter.

In another embodiment, a substrate material, such as substrate material 112, for example, may have a layer of photosensitive material formed on or above at least a portion of one or more surfaces, and a mechanism, such as mechanism 116, may deposit one or more organic materials on or above at least a portion of the photosensitive material. For example, a substrate substantially comprising a Mylar and/or Kapton material may have a layer of TiO₂ formed on or above at least a portion of at least one surface. A mechanism, such as mechanism 116, may deposit one or more organic materials, and at least a portion of the one or more organic materials have conductive properties, in at least one embodiment. For example, one or more materials substantially comprising polyanilines and/or polythiophenes, and/or one or more types of polymer, such as polymers of alkane, alkene, alkyne, branched cyclic polymers and/or aromatic polymers, for example, may be deposited on or above at least a portion of the substrate material. In this embodiment, the substrate material with one or more organic materials deposited thereon or above the substrate may be heated, such as by heating device 122 of FIG. 1b, for example. The heating device may result in at least a portion of the organic material drying, for example, although, in alternative embodiments, no heating mechanism may be utilized, as suggested previously. At least a portion of the substrate material with one or more organic materials deposited thereon or above may be provided with electromagnetic radiation, such as by electromagnetic radiation device 128, for example. The electromagnetic radiation device may selectively irradiate at least a portion of the substrate material, such as one or more portions of the layer of photosensitive material, for example. In one embodiment, one or more portions of photosensitive material with one or more organic materials deposited thereon or above may be provided with electromagnetic radiation. This results in at least a portion of the photosensitive material undergoing one or more chemical changes, for example. In this embodiment, the substrate material with one or more organic materials deposited thereon or above may have one or more additional materials deposited thereon, such as by mechanism 132 of FIG. 1b. In one embodiment, at least one of the one or more materials may comprise a material capable of reacting with at least a portion of the organic material, such as the portion of the organic material deposited on or above the photosensitive material provided with electromagnetic radiation, for example. This may result, for example, in the dissolving and/or removal of at least a portion of the organic material deposited on or above the substrate, for example. In one embodiment, wherein the organic material deposited comprises one or more polyamilines and/or polythiophenes, a material capable of reacting with the organic material may comprise water, for example In this embodiment, after providing the substrate material with one or more materials capable of reacting with the organic material, at least a portion of the organic material may be at least partially removed, resulting in a substrate material with one or more organic material regions formed thereon or above, wherein the regions comprise the regions of the substrate not provided with electromagnetic radiation, for example. These one or more organic material regions may be electrically conductive, for example, and, thus, a substrate with one or more conductive features may be formed. However, it is desirable to note that this is one particular embodiment, and claimed subject matter is not so limited, as explained in more detail later.

Illustrated in FIG. 2 is another embodiment of a conductive feature formation system, here 140; however, this is merely one example of a possible system embodiment. Many other system embodiments are possible and included within the scope of claimed subject matter. Similar to embodiment 110, this particular embodiment, 140, is capable of performing operations that may be implemented by software executing on, for example, a processor, hardware circuits, firmware, or any combination thereof. Likewise, the software may be configured to perform processing by interacting with and/or directing the actions of one or more components of formation system 140, to perform various operations, as described in more detail below.

System 140 may additionally be referred to as an RtR processing system, although it is desirable to note that this is merely one particular method of forming a device, such as device 100, and claimed subject matter is not so limited. However, continuing with this example, system 140 may include multiple deposition mechanisms, such as 146 and 150, which may comprise multiple reels, for example, and material reservoirs, such as 148 and 152, respectively, for example. In operation, a substrate material 142, which may comprise, in one embodiment, the substrate material 112 processed by system 110 of FIG. 1b, for example, may be pushed, pulled or otherwise conveyed through the reels of mechanisms 146 and/or 150, such as in a direction 144. Mechanisms 146 and/or 150 may respectively deposit one or more materials on at least a portion of at least one surface of substrate 142. For example, in one embodiment, a substrate material 142 may be pushed, pulled or otherwise conveyed at least partially through mechanism 146. Mechanism 146 may deposit a material on or above at least a portion of the substrate, such as by depositing a material from material reservoir 148 on or above at least a portion of the substrate, such as on at least a portion of the photosensitive material formed on at least a portion of the substrate, for example, and this may be referred to as roll deposition, in at least one embodiment. Additionally, substrate material 142 may be pushed, pulled or otherwise conveyed at least partially through mechanism 150, and may have another material deposited on or above at least a portion of the substrate, such as material from material reservoir 152, for example. However, it is desirable to note that claimed subject matter is not so limited, and numerous other methods for depositing material(s) on or above at least a portion of a substrate, such as substrate material 142, are included within the scope of claimed subject matter. For example, one or more spraying, drip coating, immersion and/or spreading processes may be used alternatively or additionally to one or more roll deposition processes, as described with reference to FIG. 2, for example.

In one particular embodiment, a substrate material 142, which may comprise, for example, the substrate material 112 after being processed by the system illustrated in FIG. 1b, may be provided to a system, such as system 140, for example. In this embodiment, the substrate material may have one or more photosensitive and/or organic materials formed above it or thereon, such as on or above particular portions of at least one surface of the substrate material, as explained with reference to FIG. 1 b. One or more materials may be deposited on or above at least a portion of the substrate by a deposition mechanism, such as mechanism 146, for example. In at least one embodiment, one or more materials deposited above or thereon may comprise one or more sensitizing, reducing and/or catalytic agents, such as stannous chloride, titanium chloride and/or palladium chloride, for example, and may additionally comprise a solution including hydrochloric acid, for example. In this embodiment, one or more of the aforementioned agents may adsorb and/or absorb at least a portion of the one or more organic materials deposited on or above the substrate material, and at least a portion of the substrate material may thereby be rendered catalytic, for example, although, of course, claimed subject matter is not so limited. In this embodiment, after one or more materials are deposited on or above at least a portion of the substrate material, such as on at least a portion of the organic material, one or more additional materials may be deposited on or above at least a portion of the substrate material by use of one or more additional deposition mechanisms, such as mechanism 150 of FIG. 2, for example. In one embodiment, wherein one or more sensitizing, reducing and/or catalytic agents were provided to the organic material formed on at least a portion of the substrate material, the additional material deposition may comprise, for example, one or more electroless and/or electrolytic deposition processes. For example, the organic material may be provided with a bath at least partially comprising nickel, copper, gold, lead, silver, and/or a combination thereof, such as NiCu for example, and at least a portion of the material may bond with at least a portion of the organic material, such as one or more portions of the organic material provided with one or more sensitizing, reducing and/or catalytic agents, for example. Thus, a device with one or more conductive structures, wherein at least a portion of the conductive structures are at least partially metallic, may be formed by use of electroless and/or electrolytic deposition, in this particular embodiment.

Illustrated in FIG. 3 is yet another embodiment of a conductive feature formation system 160; however, this is merely one example embodiment. Many other system embodiments are possible and included within the scope of claimed subject matter. Similarly to embodiments 110 and/or 140, this particular embodiment, 160, is capable of performing operations that may be implemented by software executing on a processor, by hardware circuits, firmware, and/or any combination thereof, and may be configured to perform processing by interacting with and/or directing the actions of one or more components of formation system 160, to perform various operations, as described in more detail below.

System 160 may additionally be referred to as an RtR processing system, although it is desirable to note that this is merely one particular method of forming a device, such as device 100, and claimed subject matter is not so limited. However, continuing with this example, system 160 may include one or more deposition mechanisms, such as 166, 170 and 176, corresponding to respective material reservoirs 168, 172 and 178, for example. An electromagnetic radiation source 174, in this particular embodiment, may provide electromagnetic radiation to the substrate 162, such as after being pushed, pulled or otherwise conveyed through mechanism 170, but before being pushed, pulled or otherwise conveyed through mechanism 176, for example. In operation, a substrate 162, which may comprise the substrate 112 processed by system 110 of FIG. 1b, and/or may comprise the substrate 142 processed by system 140 of FIG. 2, for example, may be pushed, pulled or otherwise conveyed through the reels of mechanisms 166 and 170, such as mechanically, as in a direction 164. Deposition mechanisms 166 and 170 may respectively deposit one or more materials on or above at least a portion of at least one surface of substrate 162. For example, in one embodiment, a substrate 162 with one or more materials formed above or thereon may be pushed, pulled or otherwise conveyed through mechanism 166. Mechanism 166 may deposit a material on or above at least a portion of the substrate, such as by depositing a material from reservoir 168 on to at least a portion of the photosensitive material and/or the substrate material, for example. Additionally, substrate 162 may be pushed, pulled or otherwise conveyed through mechanism 170, and may have another material, such as material from reservoir 172, deposited on or above at least a portion of the substrate, such as on or above at least a portion of the material deposited by mechanism 166, for example. Electromagnetic radiation device 174 may provide electromagnetic radiation to at least a portion of substrate 162, such as to one or more materials deposited by mechanisms 166 and/or 170, for example. In one embodiment, electromagnetic radiation device 174 comprises a laser device, and the laser device may be capable of selectively providing a laser beam 180 to one or more portions of substrate 162, such as in one or more particular patterns, and/or to one or more materials deposited by mechanisms 166 and/or 170, for example. In this embodiment, electromagnetic radiation device 174 may be capable of producing a laser beam 180 at a particular frequency or range of frequencies in the electromagnetic spectrum and having suitable energy to provide localized radiation, for example. However, alternatively, device 174 may comprise a device that produces electromagnetic radiation over a range of wavelengths in the spectrum, such as a device utilizing one or more incandescent lamps, for example. Again, selection of an electromagnetic radiation device 174 may depend at least in part on the composition of substrate material 162, and/or the material(s) deposited on substrate material 162, for example. Continuing with this example, in this embodiment, the substrate 162 may be pushed, pulled or otherwise conveyed through mechanism 176, and have one or more additional materials deposited above or thereon, such as material from reservoir 178, and deposited on or above at least a portion of the substrate 162, such as to at least a portion of the material deposited by mechanisms 166 and/or 170, for example.

In one particular embodiment, a substrate material, such as substrate material 112 processed by the system illustrated in FIG. 1b, may be provided to a system, such as system 160, for example. In this embodiment, the substrate material may have one or more photosensitive and/or organic materials formed above or thereon, such as on particular portions of at least one surface of the substrate material. One or more materials may be deposited on or above at least a portion of the substrate by a deposition mechanism, such as mechanism 166, for example. In at least one embodiment, one or more materials deposited above or thereon may comprise one or more sensitizing, reducing and/or catalytic agents, such as stannous chloride, titanium chloride and/or palladium chloride, for example, and may additionally comprise a solution including hydrochloric acid, for example. In this embodiment, one or more of the aforementioned agents may adsorb at least a portion of the substrate material and/or at least a portion of the photosensitive material, and may not adhere to the organic material, for example. At least a portion of the substrate material and/or at least a portion of the photosensitive material may thereby be rendered catalytic, for example, although, of course, claimed subject matter is not so limited. In this embodiment, after one or more materials are deposited on or above at least a portion of the substrate material and/or at least a portion of the photosensitive material, one or more additional materials may be deposited on or above at least a portion of the substrate material and/or at least a portion of the photosensitive material by use of one or more additional deposition mechanisms, such as mechanism 150 of FIG. 2, for example. In one embodiment, wherein one or more sensitizing, reducing and/or catalytic agents were provided to the substrate material and/or the photosensitive material, the additional material deposition may comprise one or more electroless deposition processes. For example, the substrate material and/or the photosensitive material may be provided with a bath at least partially comprising nickel, copper, gold, lead, silver, and/or a combination thereof, for example, and at least a portion of the material may bond with at least a portion of the substrate material and/or the photosensitive material, such as one or more portions of substrate material and/or the photosensitive material provided with one or more sensitizing, reducing and/or catalytic agents, for example. In this embodiment, an electromagnetic radiation source, such as radiation source 174, may provide electromagnetic radiation to at least a portion of the substrate material, such as to a substantial portion of the substrate, for example. The electromagnetic radiation source may provide electromagnetic radiation to one or more portions of photosensitive material formed on or above the substrate material in an earlier processing operation, for example, and, in this embodiment, the one or more materials formed on or above the substrate by electroless and/or electrolytic deposition may mask portions of the substrate from radiation, and thus portions of the substrate that did not have material deposited by electroless deposition may be provided with electromagnetic radiation, thus resulting in chemical changes in the irradiated portions of material. In this embodiment, one or more additional materials may be deposited on or above at least a portion of the substrate material and/or the photosensitive material by use of one or more additional deposition mechanisms, such as mechanism 176 of FIG. 3. for example. In one embodiment, the material deposited may comprise a material configured to react with at least a portion of the photosensitive material, such as the photosensitive material provided with electromagnetic radiation in a previous process, for example. In one embodiment, the material may comprise water, for example, and the material may dissolve and/or remove the portions of the organic layer formed on the photosensitive material provided with electromagnetic radiation, for example Thus, a device with one or more conductive structures may be formed by use of electroless deposition, in this particular embodiment.

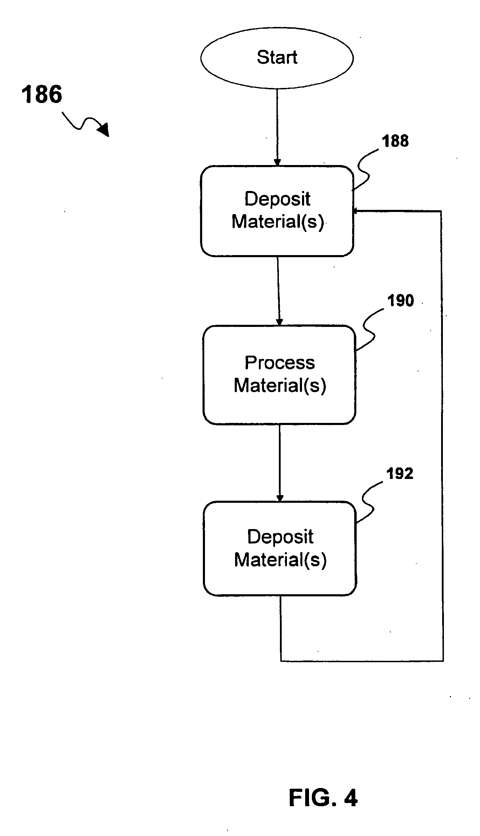

Referring now to FIG. 4, one embodiment of a technique for forming a substrate with one or more conductive features is illustrated by a flowchart, although, of course, claimed subject matter is not limited in scope in this respect. Thus, such an embodiment may be employed to at least partially form one or more conductive features, as described below. The flowchart illustrated in FIG. 4 may be used to form a device at least in part, such as device 100 of FIG. 1a, for example, although claimed subject matter is not limited in this respect. Likewise, the order in which the blocks are presented does not necessarily limit claimed subject matter to any particular order. Likewise, intervening additional blocks not shown may be employed without departing from the scope of claimed subject matter.

Flowchart 186 depicted in FIG. 4 may, in alternative embodiments, be implemented in software, hardware and/or firmware, and may comprise discrete and/or continual operations. In this embodiment, at block 188, one or more materials may be deposited on or above at least a portion of a substrate, and may comprise one or more coatings or coverings of material, for example, or may comprise a selective deposition, and may additionally comprise multiple deposition processes, for example. At block 190, one or more of the materials deposited at block 188 may be processed. This may comprise, for example, heating at least a portion of the material, and/or patterning at least a portion of the material, such as by exposing at least a portion of the material to electromagnetic radiation, for example, or may comprise removing and/or dissolving a portion of the material, such as selectively, for example. At block 192, one or more additional materials may be applied on or above at least a portion of the substrate, and may, for example, be applied to a portion of the material(s) applied and/or processed in one or more of the previous blocks, for example. Additionally, the deposition may comprise one or more coatings or coverings, for example, or may comprise a selective deposition, and may additionally comprise multiple deposition processes, for example.

In this embodiment, at block 188, one or more materials may be deposited on or above at least a portion of at least one surface of a substrate. In one embodiment, the substrate may comprise a non-conductive substrate such as a Mylar and/or Kapton material, for example, and may have a coating or covering of secondary material, such as a photosensitive material, formed on at least a portion of at least one surface. In one embodiment, a coating of TiO₂ and/or CdS may be formed on or above at least a portion of at least one surface. Likewise, a material deposited on or above the substrate at block 188 may comprise a liquid or semi-liquid, such as one or more organic and/or inorganic materials, and is conductive, and may include, for example, one or more polyanilines and/or polythiophenes and/or one or more types of polymer, such as alkane, alkene, alkyne, and/or branched cyclic or aromatic polymers, as just a few examples. Additionally, the one or more materials may be applied by one or more deposition methods, including roll deposition, ejecting, spraying, dipping, spreading and/or spin coating, for example. The material may be applied at selected locations on the substrate, such as in one or more patterns, and/or may be applied as a coating or covering above or on a substantial portion of at least one surface of the substrate, for example. In at least one example embodiment, the material may comprise a polyaniline, and may be applied by a roll deposition mechanism and a material reservoir. The material may be applied on or above one or more particular locations of the substrate, such as on or above a substantial portion of at least one surface of the substrate material, the photosensitive material, and/or the organic material, for example, as described previously. Although numerous methods of depositing one or more materials to at least a portion of at least one surface of a substrate may be in accordance with at least one embodiment, it is desirable to note that any method of deposition, resulting in a substrate having one or more materials deposited to at least a portion of at least one surface of a substrate are in accordance with at least one embodiment of claimed subject matter.

Continuing with this embodiment, at block 190, at least a portion of one or more materials deposited at block 188 may be processed. This may comprise, for example, exposing at least a portion of the material to electromagnetic radiation, for example, and/or heating at least a portion of the material, for example. Again, numerous methods exist for processing one or more materials, and the processes utilized may depend at least in part on the material applied, for example. In one embodiment, at least a portion of the one or more materials may be heated, such as by a radiative heater, for example. Additionally, after heating, in this particular embodiment, at least a portion of the one or more materials may be provided with electromagnetic radiation, such as by a laser, for example. The laser, in this embodiment, may selectively irradiate one or more portions of the material, such as in one or more patterns, for example, and, in this embodiment, portions of the deposited material(s) formed on or above one or more photosensitive materials may be irradiated, and the photosensitive material(s) reacts chemically, as explained previously.

In this embodiment, moving to block 192, one or more additional materials may be deposited on or above at least a portion of at least one surface of a substrate, such as on to one or more materials processed at block 190, for example. In at least one embodiment, a material may comprise a liquid or semiliquid, and selection of material(s) deposited may depend at least in part on the one or more materials deposited at block 188, for example. In one embodiment, wherein one or more polyanilines and/or polythiophenes are deposited on or above a substrate, and one or more portions of the deposed material are provided with electromagnetic radiation at block 190, for example, water may be deposited on or above at least a portion of the material(s), such as for at least a portion of the material(s) provided with electromagnetic radiation, for example. Although numerous methods exist for depositing a material such as water, one or more deposition methods, including one or more spraying, spin coating, drip coating, immersion and/or spreading processes may be used in at least one embodiment. The material may be applied at selected locations on the substrate to at least a portion of at least one material processed at block 190, and/or may be applied as a coating or covering on or above a substantial portion of at least one surface of the substrate, for example. This may result, for example, in at least a portion of the material(s) irradiated at block 190 being removed and/or dissolved, for example. Additionally, one or more additional materials may be deposited on or above at least a portion of the substrate at block 192. Numerous methods exist for depositing one or more materials, including electroless and electrolytic deposition, and the deposition mechanism(s) may be similar or may vary from the one or more mechanisms utilized at block 188, for example. Although numerous methods of depositing one or more materials on or above at least a portion of at least one surface of a substrate may be in accordance with at least one embodiment, it is desirable to note that any method of deposition, resulting in a substrate having one or more materials deposited on or above at least a portion of at least one surface of a substrate is included within the scope of claimed subject matter. In one embodiment, one or more sensitizing, reducing and/or catalytic agents may be deposited on or above at least a portion of the substrate, and additionally, one or more conductive materials, such as one or more materials at least partially comprising metal, may be deposited on or above at least a portion of the substrate, such as for one or more portions of the substrate being provided with one or more organic materials at block 188, for example. The one or more conductive materials may be adsorbed and/or absorbed, and may be deposited on or above at least a portion of the organic material(s), for example.

It is, of course, now appreciated, based at least in part on the foregoing disclosure, that software may be produced capable of performing one or more of the foregoing operations. It will, of course, also be understood that, although particular embodiments have just been described, claimed subject matter is not limited in scope to a particular embodiment or implementation. For example, one embodiment may be in hardware, such as implemented to operate on a device or combination of devices as previously described, for example, whereas another embodiment may be in software. Likewise, an embodiment may be implemented in firmware, or as any combination of hardware, software, and/or firmware, for example. Additionally, all or a portion of one embodiment may be implemented to operate partially in one device, such as a deposition device, and partially in a computing device, for example. Likewise, although claimed subject matter is not limited in scope in this respect, one embodiment may comprise one or more articles, such as a storage medium or storage media. This storage media, such as, one or more CD-ROMs and/or disks, for example, may have stored thereon instructions, that when executed by a system, such as a computer system, computing platform, or other system, for example, may result in an embodiment of a method in accordance with claimed subject matter being executed, such as one of the embodiments previously described, for example. As one potential example, a computing platform may include one or more processing units or processors, one or more input/output devices, such as a display, a keyboard and/or a mouse, and/or one or more memories, such as static random access memory, dynamic random access memory, flash memory, and/or a hard drive, although, again, claimed subject matter is not limited in scope to this example.

## Claims

1. A method for forming a substrate for electronic devices comprising:
depositing a first material (118) comprising a conductive organic material on photosensitive material (104) that coats or covers a substrate (102, 112);
selectively applying electromagnetic radiation (134) to a portion of said photosensitive material (104) with said first material (118) deposited thereon to result in chemical changes in at least a portion of the photosensitive material; and
applying a second material (130) to a portion of said first material (118) to at least partially remove a portion of said first material (118).

2. The method of claim 1, wherein said applying a second material (130) to said portion of said first material (118), comprises:
applying said second material (130) to said portion of said first material (118), wherein applying said second material (130) results in dissolving at least a portion of said first material (118).

3. The method of claim 1, and further comprising
depositing a third material (148, 168) on at least a portion of the remaining first material (118) to render at least a portion of the remaining said first material (118) at least partially catalytic, wherein said third material (148, 168) substantially comprises one or more sensitizing, reducing and/or catalytic agents.

4. The method of claim 3, and further comprising:
depositing a fourth material (152, 172) on at least a portion of said third material (148, 168), wherein said fourth material (152, 172) is deposited substantially by the use of a process comprising one or more of: electroless plating and/or electrolytic plating, wherein said fourth materials at least partially comprises one or more of: nickel, copper, gold, lead and/or silver.

5. The method of claim 1, and further comprising:
depositing a third material (148, 168) on at least a portion of said photosensitive material (104) selectively provided with electromagnetic radiation (134), to render at least a portion of the remaining said photosensitive material (104) at least partially catalytic, wherein said third material (148, 168) substantially comprises one or more sensitizing, reducing and/or catalytic agents.

6. The method of claim 5, and further comprising:
depositing a fourth material (152, 172) on at least a portion of said third material (148, 168), wherein said fourth material (152, 172) is deposited substantially by the use of a process comprising one or more of, electroless plating and/or electrolytic plating, wherein said fourth material, at least partially comprises one or more of: nickel, copper, gold, lead and/or silver.

## Patentansprüche

1. Verfahren, zum Herstellen eines Substrats für elektronische Vorrichtungen, Folgendes umfassend:
Auftragen eines ersten Materials (118), das ein leitendes organisches Material umfasst, auf einem fotoempfindlichen Material (104), das ein Substrat (102, 112) beschichtet oder abdeckt,
selektives Anwenden elektromagnetischer Strahlung (134) auf einen Teil des fotoempfindlichen Materials (104), auf dem das erste Material (118) aufgetragen ist, um hierdurch chemische Veränderungen in wenigstens einem Teil des fotoempfindlichen Materials zu bewirken, und
Anwenden eines zweiten Materials (130) auf einen Teil des ersten Materials (118), um wenigstens teilweise einen Teil des ersten Materials (118) zu entfernen.

2. Verfahren nach Anspruch 1, wobei das Anwenden eines zweiten Materials (130) auf den Teil des ersten Materials (118) Folgendes umfasst:
Anwenden des zweiten Materials (130) auf den Teil des ersten Materials (118), wobei das Anwenden des zweiten Materials (130) zum Auflösen wenigstens eines Teils des ersten Materials (118) führt.

3. Verfahren nach Anspruch 1, das außerdem Folgendes umfasst:
Auftragen eines dritten Materials (148, 168) auf wenigstens einem Teil des verbleibenden ersten Materials (118), um wenigstens einen Teil des verbleibenden ersten Materials (118) wenigstens teilweise katalytisch zu machen, wobei das dritte Material (148, 168) im Wesentlichen einen oder mehrere sensibilisierende, reduzierende und/oder katalytische Wirkstoffe umfasst.

4. Verfahren nach Anspruch 3, das außerdem Folgendes umfasst:
Auftragen eines vierten Materials (152, 172) auf wenigstens einem Teil des dritten Materials (148, 168), wobei das vierte Material (152, 172) im Wesentlichen unter Verwendung eines Prozesses aufgetragen wird, der eines oder mehrere der folgenden Verfahren umfasst: stromloses Beschichten und/oder elektrolytisches Beschichten, wobei das vierte Material wenigstens teilweise eines oder mehrere der folgenden Materialien umfasst: Nickel, Kupfer, Gold, Blei und/oder Silber.

5. Verfahren nach Anspruch 1, das außerdem Folgendes umfasst:
Auftragen eines dritten Materials (148, 168) auf wenigstens einem Teil des fotoempfindlichen Materials (104), das selektiv durch elektromagnetische Strahlung (134) bearbeitet wurde, um wenigstens einen Teil des verbleibenden fotoempfindlichen Materials (104) wenigstens teilweise katalytisch zu machen, wobei das dritte Material (148, 168) im Wesentlichen einen oder mehrere sensibilisierende, reduzierende und/oder katalytische Wirkstoffe umfasst.

6. Verfahren nach Anspruch 5, das außerdem Folgendes umfasst:
Auftragen eines vierten Materials (152, 172) auf wenigstens einem Teil des dritten Materials (148, 168), wobei das vierte Material (152, 172) im Wesentlichen unter Verwendung eines Prozesses aufgetragen wird, der eines oder mehrere der folgenden Verfahren umfasst: stromloses Beschichten und/oder elektrolytisches Beschichten, wobei das vierte Material wenigstens teilweise eines oder mehrere der folgenden Materialien umfasst: Nickel, Kupfer, Gold, Blei und/oder Silber.

## Revendications

1. Procédé de formation d'un substrat pour dispositifs électroniques, comprenant :
le dépôt d'un premier matériau (118) comprenant un matériau organique conducteur sur un matériau photosensible (104) qui revêt ou couvre un substrat (102, 112) ;
l'application, de manière sélective, d'un rayonnement électromagnétique (134) à une partie dudit matériau photosensible (104) avec ledit premier matériau (118) déposé sur celui-ci pour produire des modifications chimiques dans au moins une partie du matériau photosensible ; et
l'application d'un second matériau (130) sur une partie dudit premier matériau (118) pour au moins partiellement enlever une partie dudit premier matériau (118).

2. Procédé selon la revendication 1, dans lequel ladite application d'un second matériau (130) sur ladite partie dudit premier matériau (118) comprend :
l'application dudit second matériau (130) sur ladite partie dudit premier matériau (118), dans lequel l'application dudit second matériau (130) entraîne la dissolution d'au moins une partie dudit premier matériau (118).

3. Procédé selon la revendication 1, et comprenant en outre :
le dépôt d'un troisième matériau (148, 168) sur au moins une partie du premier matériau restant (118) pour rendre au moins une partie du reste dudit premier matériau (118) au moins partiellement catalytique, dans lequel ledit troisième matériau (148, 168) comprend substantiellement un ou plusieurs sensibilisateurs, réducteurs et/ou catalyseurs.

4. Procédé selon la revendication 3, et comprenant en outre :
le dépôt d'un quatrième matériau (152, 172) sur au moins une partie dudit troisième matériau (148, 168), dans lequel ledit quatrième matériau (152, 172) est déposé substantiellement en utilisant un procédé comprenant un ou plusieurs éléments parmi : le dépôt autocatalytique et/ou le dépôt électrolytique, dans lequel ledit quatrième matériau comprend au moins partiellement un ou plusieurs éléments parmi : le nickel, le cuivre, l'or, le plomb et/ou l'argent.

5. Procédé selon la revendication 1, et comprenant en outre :
le dépôt d'un troisième matériau (148, 168) sur au moins une partie dudit matériau photosensible (104) exposée sélectivement à un rayonnement électromagnétique (134), pour rendre au moins une partie du reste dudit matériau photosensible (104) au moins partiellement catalytique, dans lequel ledit troisième matériau (148, 168) comprend substantiellement ou un plusieurs sensibilisateurs, réducteurs et/ou catalyseur.

6. Procédé selon la revendication 5, et comprenant en outre :
le dépôt d'un quatrième matériau (152, 172) sur au moins une partie dudit troisième matériau (148, 168), dans lequel ledit quatrième matériau (152, 172) est déposé substantiellement en utilisant un procédé comprenant un ou plusieurs éléments parmi : le dépôt autocatalytique et/ou le dépôt électrolytique, dans lequel ledit quatrième matériau comprend au moins partiellement un ou plusieurs éléments parmi : le nickel, le cuivre, l'or, le plomb et/ou l'argent.
